# EUROPÄISCHE PATENTSCHRIFT

(11) **EP 3 421 940 B1**
(45) Veröffentlichungstag und Bekanntmachung des Hinweises auf die Patenterteilung: **13.05.2020**
(21) Anmeldenummer: 18163943.6
(22) Anmeldetag: 26.03.2018
(51) Int. Cl.: G01D 3/028, G01R 27/14

(54) **SENSORSCHALTUNGSANORDNUNG**
SENSOR CIRCUIT ASSEMBLY
CIRCUIT DE CAPTEUR

(30) Priorität: 26.06.2017 DE 102017210681
(43) Veröffentlichungstag der Anmeldung: 02.01.2019
(73) Patentinhaber: Dr. Johannes Heidenhain GmbH, 83301 Traunreut (DE)
(72) Erfinder: OLLERT, Udo, 84558 Kirchweidach (DE)

(56) Entgegenhaltungen:
- EP-A1- 0 536 286
- DE-A1- 3 101 994
- DE-A1-102013 009 748
- US-A- 4 185 167

## Beschreibung

### GEBIET DER TECHNIK

Die vorliegende Erfindung betrifft eine Sensorschaltungsanordnung nach Anspruch 1, sowie ein Verfahren zur Auswertung einer derartigen Sensorschaltungsanordnung nach Anspruch 9. Außerdem betrifft die Erfindung ein System zur Auswertung einer erfindungsgemäßen Sensorschaltungsanordnung nach Anspruch 11. Die Erfindung ist auf dem Gebiet der Automatisierungstechnik angeordnet und ermöglicht die Auswertung eines Widerstandssensors und einer Anzahl von schaltenden Sensoren mit geringem Verkabelungsaufwand. Sie ist insbesondere in Fertigungsanlagen, bei Werkzeugmaschinen, sowie in der Aufzugstechnik einsetzbar.

### STAND DER TECHNIK

Der Ablauf vieler Funktionen in der Automatisierungstechnik wird von programmierbaren Steuerungen gesteuert. Hierzu gehört das Steuern von Antrieben genauso wie die Überwachung von Funktionsparametern. Antriebe werden beispielsweise von Regelkreisen gesteuert, indem auf der Basis von Istwerten (insbesondere Lageistwerten) Sollwerte eingestellt werden. Diese Art der Rückkopplung ermöglicht die genaue Positionierung des Antriebs, bzw. eines vom Antrieb bewegten Maschinenteils. Zur Erfassung der Lageinformation werden Lagesensoren (Drehgeber oder Längenmessgeräte) eingesetzt, die mit der Steuerung über eine digitale Datenschnittstelle verbunden sind. Die Kommunikation erfolgt meist in Form von Datenpaketen, die in serieller Form übertragen werden.

Zur Überwachung von Funktionsparametern gehört unter anderem die Messung von Umgebungsvariablen, um festzustellen, ob eine Anlage innerhalb zugelassener Grenzwerte funktioniert, beispielsweise ob ein vorgeschriebener Temperaturbereich eingehalten wird oder nicht. Sensoren, die hier eingesetzt werden, sind häufig Widerstandssensoren, also Sensoren bei denen sich der elektrische Widerstand in Abhängigkeit von der zu messenden Umgebungsvariablen ändert. Typisches Beispiel hierfür sind Platin-Messwiderstände zur Temperaturmessung.

Funktionsparameter können aber auch von schaltenden Sensoren überwacht werden, beispielsweise von Endschaltern oder Türkontakten. In Verbindung mit Elektromotoren dienen Schalter zur Verschleißanzeige von Bremsscheiben oder zur Lüftüberwachung von Motorbremsen als schaltende Sensoren.

Für den klassischen Einsatz von Sensoren weist die Steuerung analoge oder digitale Schnittstellen auf, an die die Sensoren angeschlossen werden. Da die Sensoren meist aber in einem großen räumlichen Abstand von der Steuerung angeordnet sind, ergibt sich hierbei ein erheblicher Aufwand für die Verkabelung.

Die DE 10 2006 041 056 A1 beschreibt eine Positionsmesseinrichtung (Drehgeber), der über eine Vielzahl von Sensorschnittstellen verfügt. Hier kann die digitale Schnittstelle mitgenutzt werden, um Sensordaten zur Steuerung zu übertragen. Da der Positionssensor häufig in der Nähe der anderen Sensoren betrieben wird, bedeutet das einen geringeren Verkabelungsaufwand. Allerdings ist das Vorsehen von mehreren Sensorschnittstellen am Positionssensor aufwändig und oft mangels Platz am Gehäuse des Positionssensors nicht möglich.

### ZUSAMMENFASSUNG DER ERFINDUNG

Es ist daher Aufgabe der Erfindung, eine vereinfachte Sensorschaltungsanordnung zu schaffen.

Es wird eine Sensorschaltungsanordnung mit einem Widerstandssensor, wenigstens einem schaltenden Sensor und wenigstens einem Hilfswiderstand vorgeschlagen, die einen Schaltkreis mit einem Summenwiderstand bilden, wobei der Summenwiderstand einerseits vom Widerstandswert des Hilfswiderstands in Kombination mit dem Schaltzustand des schaltenden Sensors und andererseits vom Widerstandswert des Widerstandssensors abhängig ist und wobei der Widerstandssensor ein Temperatursensor ist.

Zur Bildung der Sensorschaltungsanordnung wird eine Vorrichtung vorgeschlagen, an die der Widerstandssensor und der wenigstens eine schaltende Sensor anschließbar sind und von der der Summenwiderstand an eine Auswerteeinheit ausgebbar ist, wobei die Vorrichtung ein Gehäuse umfasst, in dem der wenigstens einen Hilfswiderstand, sowie Verbindungsmittel zur Bildung des Schaltkreises angeordnet sind

Weiter ist es Aufgabe der Erfindung, ein Verfahren zur Auswertung einer erfindungsgemäßen Sensorschaltungsanordnung zur schaffen.

Diese Aufgabe wird gelöst durch ein Verfahren zur Auswertung einer Sensorschaltungsanordnung nach Anspruch 9.

Hierzu wird ein Verfahren zur Auswertung einer Sensorschaltungsanordnung mit folgenden Schritten vorgeschlagen:
- Messung des Summenwiderstands,
- Ermittlung des Schaltzustandes des wenigstens einen schaltenden Sensors,
- Berechnung des Wertes des Widerstandssensors aus dem Schaltzustand des wenigstens einen schaltenden Sensors und dem Wert des wenigstens einen Hilfswiderstands.

Eine weitere Aufgabe der vorliegenden Erfindung ist es, ein System zur Auswertung einer erfindungsgemäßen Sensorschaltungsanordnung zu schaffen.

Diese Aufgabe wird gelöst durch ein System zur Auswertung einer Sensorschaltungsanordnung nach Anspruch 11.

Es wird ein System zur Auswertung einer Sensorschaltungsanordnung vorgeschlagen, mit einer Auswerteeinheit in Form einer Positionsmesseinrichtung, wobei in der Positionsmesseinrichtung eine Widerstandsverarbeitungseinheit zur Messung des Summenwiderstands angeordnet ist, sowie eine Schnittstelleneinheit zur Kommunikation mit einer Steuerung über einen bidirektionalen Datenübertragungskanal.

Der Einsatz einer Positionsmesseinrichtung ist besonders vorteilhaft, da Positionsmesseinrichtungen häufig in Verbindung mit schaltenden Sensoren und Widerstandssensoren eingesetzt werden und in räumlicher Nähe der Sensoren angeordnet sind.

Weitere Vorteile der Erfindung ergeben sich aus den von den unabhängigen Ansprüchen 1, 7, 9 und 11 abhängigen Ansprüchen, sowie aus der nachfolgenden Beschreibung vorteilhafter Ausführungsbeispiele.

### KURZE BESCHREIBUNG DER ZEICHNUNGEN

Es zeigt
- Figur 1: ein Prinzipschaltbild eines ersten Ausführungsbeispiels einer erfindungsgemäßen Sensorschaltungsanordnung,
- Figur 2: ein Prinzipschaltbild eines zweiten Ausführungsbeispiels einer erfindungsgemäßen Sensorschaltungsanordnung,
- Figur 3: ein Prinzipschaltbild eines dritten Ausführungsbeispiels einer erfindungsgemäßen Sensorschaltungsanordnung,
- Figur 4: den Verlauf des Summenwiderstands des Ausführungsbeispiels von Figur 3 und
- Figur 5: ein Blockschaltbild einer Sensorschaltungsanordnung in Verbindung mit einer Auswerteeinheit.

### BESCHREIBUNG DER AUSFÜHRUNGSFORMEN

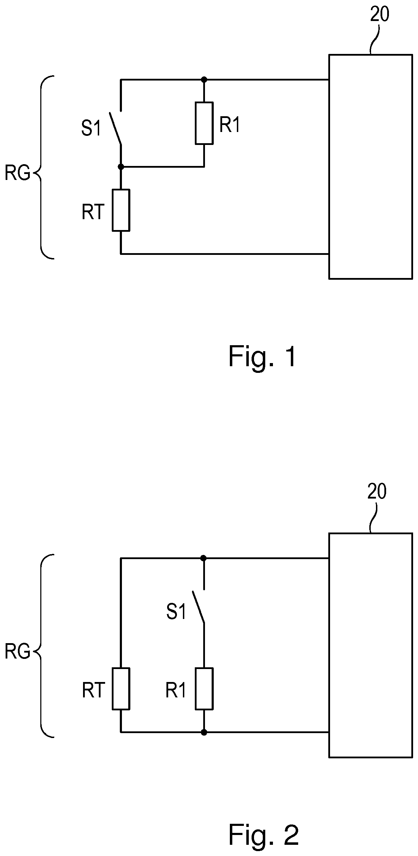

Figur 1 zeigt ein Prinzipschaltbild eines ersten Ausführungsbeispiels einer erfindungsgemäßen Sensorschaltungsanordnung, die einen Widerstandssensor RT, einen schaltenden Sensor S1, sowie einen Hilfswiderstand R1 umfasst. Der Widerstandssensor RT ist ein Temperatursensor (PT1000, KTY84-130, etc.). Bei dem schaltenden Sensor kann es sich um einen Endschalter, Türkontakt, einen Kontakt zur Verschleißanzeige einer Bremsscheibe, usw. handeln.

Der Widerstandssensor RT und der schaltende Sensor S1 sind in Reihe geschaltet, der Hilfswiderstand R1 ist parallel zum schaltenden Sensor S1 angeordnet. In dieser Anordnung ergibt sich ein Summenwiderstand RG = RT + R1, solange der Schaltkontakt des schaltenden Sensors S1 geöffnet ist, und ein Summenwiderstand RG = RT bei geschlossenen Schaltkontakt des schaltenden Sensors S1. Daraus folgt zum einen, dass der Summenwiderstand RG, unabhängig vom Schaltzustand des schaltenden Sensors S1, immer auch vom Widerstandssensor RT abhängt und zum andern, dass ein Schaltvorgang des schaltenden Sensors S1 zu einem Sprung des Wertes des Summenwiderstands RG um den Wert des Hilfswiderstands R1 führt.

Die vorliegende Erfindung basiert auf der Erkenntnis, dass aus dem Summenwiderstand RG sowohl der Schaltzustand des schaltenden Sensors S1, als auch der Wert des Widerstandssensors RT ermittelbar ist.

Ist der Hilfswiderstand R1 so dimensioniert, dass in einem der Schaltzustände des schaltenden Sensors S1 der Summenwiderstand RG außerhalb des Wertebereiches des Widerstandssensors RT liegt, so kann der Schaltzustand des schaltenden Sensors jederzeit durch Messung des Summenwiderstands RG ermittelt werden. Liegt der Wertebereich des Widerstandssensors RT beispielsweise zwischen 1000 Ohm und 1500 Ohm (entsprechend den Grenzen des Temperaturbereichs, den der Widerstandssensor RT abdecken muss) und der Hilfswiderstand R1 hat einen Wert von 600 Ohm, so liegt der Wertebereich des Summenwiderstands RG im offenen Zustand des schaltenden Sensors S1 zwischen 1600 Ohm und 2100 Ohm und daher immer außerhalb (oberhalb) des Wertebereichs des Widerstandssensors RT. Der Schaltzustand des schaltenden Sensors S1 kann also sicher zugeordnet und der Wert des Widerstandssensors RT und damit die Temperatur berechnet werden.

Ist der Hilfswiderstand R1 dagegen so dimensioniert, dass der Summenwiderstand RG in beiden Schaltzuständen des schaltenden Sensors S1 zumindest teilweise innerhalb des Wertebereichs des Widerstandssensors RT liegt, so ist der Schaltzustand des schaltenden Sensors S1 dennoch sicher ermittelbar, wenn der Summenwiderstand RG kontinuierlich in kurzen Zeitabständen wiederholt ermittelt wird. Hier kann man sich die Tatsache zu Nutze machen, dass sich der Widerstandswert des Widerstandssensors RT Prinzip bedingt nur langsam und stetig ändern kann, während ein Schaltvorgang des schaltenden Sensors S1 eine sprunghafte Änderung des Summenwiderstands RG bewirkt. Wählt man die Abtastrate (also die Zeitabstände zwischen zwei Messungen des Summenwiderstands RG) so, dass ein Schaltvorgang des schaltenden Sensors S1 anhand von der Änderung des Summenwiderstands RG sicher von einer temperaturbedingten Änderung des Widerstands des Widerstandssensors RT unterscheidbar ist, so kann wieder aus der Messung des Summenwiderstands RG sowohl der Schaltzustand des schaltenden Sensors S1 bestimmt, als auch der Widerstandswert des Widerstandssensors RT berechnet werden.

Für die Auswertung des Summenwiderstands RG ist die Sensorschaltungsanordnung an eine Auswerteeinheit 20 anschließbar.

Figur 2 zeigt ein Prinzipschaltbild eines zweiten Ausführungsbeispiels einer erfindungsgemäßen Sensorschaltungsanordnung. Die bereits in Verbindung mit Figur 1 eingeführten Bezugszeichen bleiben unverändert.

In dieser Variante sind der Widerstandssensor RT und eine Reihenschaltung aus dem schaltenden Sensor S1 und dem Hilfswiderstand R1 parallelgeschaltet. Ist der schaltende Sensor S1 wie dargestellt ausgeschaltet, dann entspricht der Summenwiderstand RG dem Wert des Widerstandssensors RT. Ist der Kontakt des schaltenden Sensors S1 dagegen geschlossen, so ergibt sich als Summenwiderstand RG eine Parallelschaltung aus dem Widerstandssensor RT und dem Hilfswiderstand R1. Auch hier bestimmt die Dimensionierung des Hilfswiderstands R1, ob der Schaltzustand des schaltenden Sensors S1 jederzeit durch Messung des Summenwiderstands RG ermittelt werden kann, oder ob durch kontinuierlich in kurzen Zeitabständen wiederholte Messungen des Summenwiderstands RG sprunghafte Änderungen des Wertes des Summenwiderstandes RG und damit Änderungen des Schaltzustandes des schaltenden Sensors S1 erkannt werden können.

Die in den Figuren 1 und 2 dargestellten Sensorschaltungsanordnungen zeigen Grundschaltungen der vorliegenden Erfindung, die ein Fachmann im Rahmen der Ansprüche variieren kann. So können durch geeignete Reihen-und/oder Parallelschaltungen weiterer schaltender Sensoren und Hilfswiderstände die Schaltzustände mehrerer schaltender Sensoren bestimmt werden. Mit Vorteil ist die Art der Schaltung, sowie die Dimensionierung der Hilfswiderstände dabei so gewählt, dass anhand des Summenwiderstands RG, bzw. Sprüngen des Wertes des Summenwiderstandes RG auf die Schaltzustände der schaltenden Sensoren geschlossen werden kann. Soll gewährleistet sein, dass immer auch eine Bestimmung des Wertes des Widerstandssensors RT möglich ist, so ist die Schaltung so zu gestalten, dass bei jeder Zustandskombination der schaltenden Sensoren der Wert des Widerstandssensors RT ein Teil des Summenwiderstands RG ist, d.h. der Widerstandssensor RT darf nicht ausgeschaltet oder überbrückt werden.

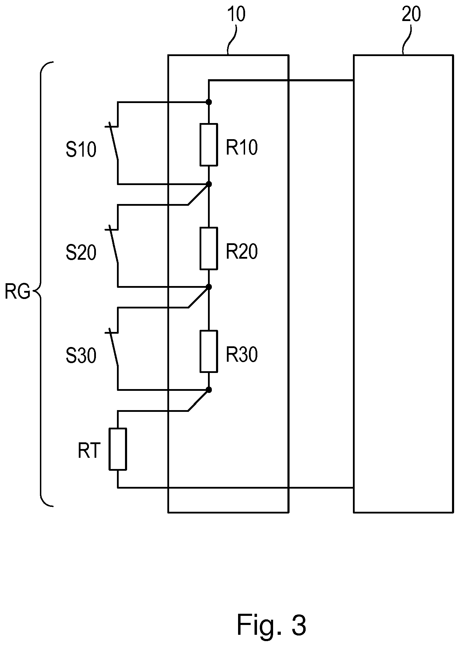

Figur 3 zeigt ein Prinzipschaltbild eines dritten Ausführungsbeispiels einer erfindungsgemäßen Sensorschaltungsanordnung. Diese vorteilhafte Variante umfasst drei schaltende Sensoren S10, S20, S30 mit ihnen zugeordneten Hilfswiderständen R10, R20, R30, sowie den Widerstandssensor RT. Je ein schaltender Sensor S10, S20, S30 ist mit einem Hilfswiderstand R10, R20, R30 parallelgeschaltet, die parallelgeschalteten Komponenten sind wiederum mit dem Widerstandssensor RT in einer Reihenschaltung verbunden. Die äußeren Anschlüsse der Reihenschaltung umfassen den Summenwiderstand RG, der in der Auswerteeinheit 20 ausgewertet wird.

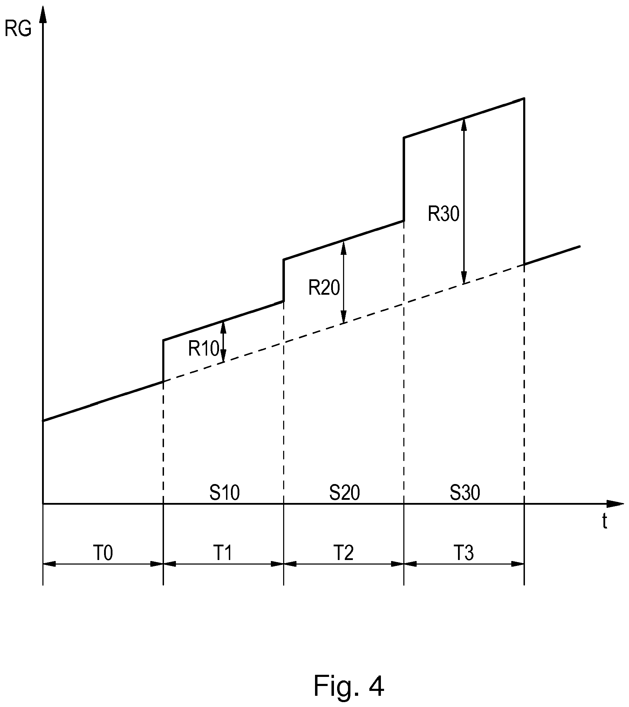

Figur 4 zeigt den Verlauf des Summenwiderstands RG des Ausführungsbeispiels von Figur 3. Vereinfachend wird ein linearer Anstieg des Wertes des Widerstandssensors RT (entsprechend einem konstanten Temperaturanstieg) über den dargestellten Zeitraum angenommen, was zu eine konstanten Steigung des Widerstandsverlaufs führt, solange keiner der schaltenden Sensoren S10, S20, S30 betätigt wird. Abweichend zu den Figuren 1 und 2 sind die schaltenden Sensoren S10, S20, S30 im Ruhezustand geschlossen und unterbrechen den Stromkreis im betätigten Zustand (Öffnerkontakt). Im betätigten Zustand sind die jeweiligen Hilfswiderstände R10, R20, R30 somit eingeschaltet.

Im Zeitraum T0 ist keiner der schaltenden Sensoren betätigt, im Zeitraum T1 ist der schaltende Sensor S10 betätigt, im Zeitraum T2 der schaltende Sensor S20 und im Zeitraum T3 der schaltende Sensor S30. Die Betätigung eines schaltenden Sensors S10, S20, S30 bewirkt jeweils einen Sprung im Widerstandswert des Summenwiderstands RG. Wie aus dem Verlauf des Summenwiderstands RG ersichtlich, weisen die Hilfswiderstände R10, R20, R30 unterschiedliche Werte auf, was sich in verschieden hohen Sprüngen des Wertes des Summenwiderstands RG auswirkt. Sind die Widerstandswerte R10, R20, R30 darüber hinaus so gewählt, dass jede Schaltkombination der schaltenden Sensoren S10, S20, S30 eine unterschiedliche Änderung des Summenwiderstands RG bewirkt, so ist durch Überwachung des Wertes des Summenwiderstands RG der Schaltzustand jedes der schaltenden Sensoren S10, S20, S30 eindeutig bestimmbar.

Es sei darauf hingewiesen, dass die Kriterien bezüglich der Dimensionierung der Hilfswiderstände R10, R20, R30 selbstverständlich auch auf eine Parallelschaltung oder eine Reihen-Parallelschaltung der Hilfswiderstände R10, R20, R30 bzw. schaltenden Sensoren S10, S20, S30 anwendbar sind.

Besonders vorteilhaft ist es nun, wenn die Hilfswiderstände R10, R20, R30 so dimensioniert sind, dass ihre Werte binär abgestuft sind, also beispielsweise gilt: R20 = 2 * R10 und R30 = 4 * R10. In diesem Fall weisen die Wertesprünge des Summenwiderstands RG bei jeglicher Kombination von Schaltzuständen immer ein Vielfaches des Wertes des kleinsten Hilfswiderstands (in diesem Fall R10) auf. Dieser Zusammenhang kann zu einer Plausibilitätsprüfung der Widerstandsmessung verwendet werden.

Die schaltenden Sensoren S10, S20, S30 und der Widerstandssensor RT sind meist an verschiedenen Orten der zu überwachenden Anlage angeordnet. Deshalb ist es vorteilhaft, eine Vorrichtung zu schaffen, die an einer zentralen Stelle der Anlage angeordnet ist und an die einerseits die schaltenden Sensoren S10, S20, S30 und der Widerstandssensor RT anschließbar sind und die andererseits den Summenwiderstand RG an die Auswerteeinheit 20 ausgibt. Diese Vorrichtung weist ein Gehäuse 10 auf, innerhalb dessen die Hilfswiderstände R10, R20, R30 angeordnet sind, sowie Verbindungsmittel zur Bildung der Sensorschaltungsanordnung. Die Verbindungsmittel umfassen elektrische Leitungen, sowie Steck-, Schraubklemm-, Klemm- oder Lötverbinderfür den Anschluss der schaltenden Sensoren S10, S20, S30, des Widerstandssensors RT und der Auswerteeinheit 20.

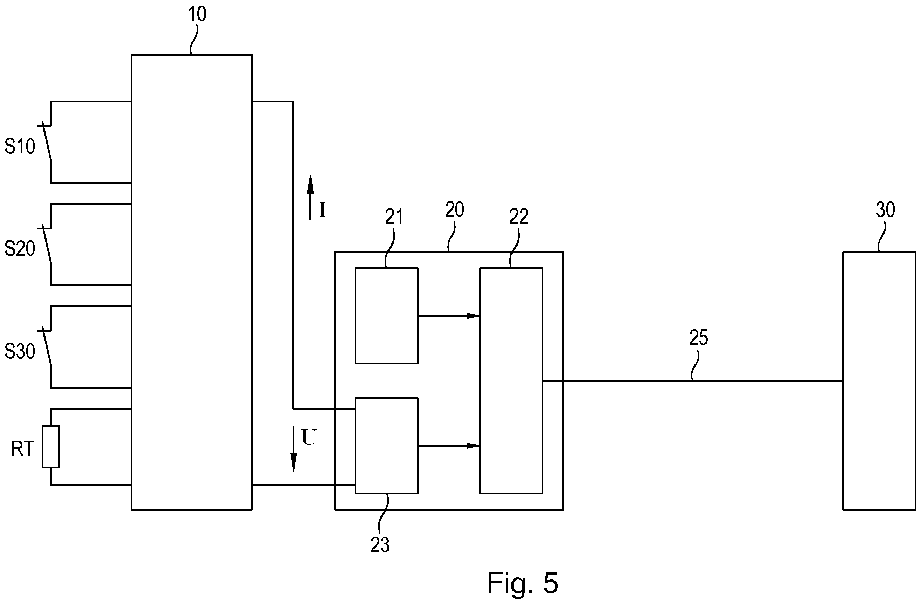

Figur 5 zeigt nun ein System zur Sensorauswertung. Es umfasst eine erfindungsgemäße Sensorschaltungsanordnung und eine Positionsmesseinrichtung als Auswerteeinheit 20.

Der grundsätzliche Aufbau einer geeigneten Positionsmesseinrichtung kann beispielsweise der eingangs erwähnten DE 10 2006 041 056 A1 entnommen werden.

Die Positionsmesseinrichtung 20 umfasst zur bestimmungsgemäßen Erzeugung von Positionswerten eine Positionserfassungseinheit 21, die durch Abtastung einer Messteilung auf einem Teilungsträger positionsabhängige Signale generiert und zu Positionswerten verarbeitet.

Weiter umfasst die Positionsmesseinrichtung 20 eine Schnittstelleneinheit 22, die eine Kommunikation mit einer Steuerung 30 über einen Datenübertragungskanal 25 ermöglicht. Die Kommunikation erfolgt durch Übertragung von Befehlen und ggf. Daten von der Steuerung 30 zur Positionsmesseinrichtung 20, sowie durch Übertragung von Antwortdaten (beispielsweise den Positionswerten) von der Positionsmesseinrichtung 20 zur Steuerung 30.

Zur Messung und ggf. Auswertung des Summenwiderstands RG weist die Positionsmesseinrichtung 20 eine Widerstandsverarbeitungseinheit 23 auf. Die Widerstandsmessung kann dadurch erfolgen, dass die Widerstandsverarbeitungseinheit 23 einen Messstrom I in Richtung des Summenwiderstands RG ausgibt, den daraus resultierenden Spannungsabfall U am Summenwiderstand RG misst und den Summenwiderstand RG aus Messstrom I und Spannungsabfall U errechnet.

Der Messstrom I kann Gleich- oder Wechselstrom sein. Alternative Messmethoden sind an dieser Stelle ebenfalls einsetzbar. Die Auswertung des Summenwiderstands RG kann in der Steuerung 30 erfolgen, sie kann aber auch bereits in der Widerstandsverarbeitungseinheit 23 vorgenommen werden.

Im ersten Fall ist der Summenwiderstand RG der Schnittstelleneinheit 22 zugeführt und kann von dort zur Steuerung 30 übertragen werden. Die Messung des Summenwiderstands RG kann automatisch von der Widerstandsverarbeitungseinheit 23 in kurzen Zeitabständen wiederholt durchgeführt werden. Auf diese Weise ist stets ein aktueller Widerstandswert für die Steuerung 30 verfügbar, den diese befehlsgesteuert von der Schnittstelleneinheit 22 anfordern kann. Alternativ wird die Widerstandsmessung nur durchgeführt, wenn entsprechende Befehle von der Steuerung 30 bei der Schnittstelleneinheit 22 eintreffen. Die Übertragung der Befehle und die daraus resultierenden Messungen können wiederum in kurzen Zeitabständen wiederholt erfolgen. Die Auswertung des Summenwiderstands RG erfolgt in der Steuerung 30 abhängig von der Dimensionierung der Hilfswiderstände wie oben beschrieben direkt aus dem Wert des Summenwiderstands RG, oder durch Analyse sprunghafter Änderungen des Wertes des Summenwiderstands RG. In diesem Fall ist die Steuerung 30 der Auswerteeinheit 20 zuzuordnen.

Im zweiten Fall erfolgt die Auswertung des Summenwiderstands RG bereits in der Widerstandsverarbeitungseinheit 23. Auch in diesem Fall kann die Widerstandsmessung automatisch von der Widerstandsverarbeitungseinheit 23, oder gesteuert von Befehlen der Steuerung 30 erfolgen. Nun ermittelt die Widerstandsverarbeitungseinheit 23 anstelle der Steuerung 30 aber auch die Schaltzustände der schaltenden Sensoren S10, S20, S30, sowie den Wert des Widerstandssensors RT. Die ermittelten Werte sind über die Schnittstelleneinheit 22 von der Steuerung 30 abrufbar.

Das beschriebene System ist dann besonders vorteilhaft, wenn die erfindungsgemäße Sensorschaltungsanordnung in Verbindung mit einem Servoantrieb eingesetzt wird. Hier ist eine geeignete Positionsmesseinrichtung 20 zusammen mit der Kabelverbindung, die den Datenübertragungskanal 25 beinhaltet, in der Regel bereits vorhanden. Das Gehäuse 10 der Sensorschaltungsanordnung ist mit Vorteil in räumlicher Nähe zur Positionsmesseinrichtung 20 an einem für Servicepersonal zugänglichen Ort angeordnet.

Die vorliegende Erfindung ist selbstverständlich nicht auf die beschriebenen Ausführungsbeispiele eingeschränkt, sondern kann von einem Fachmann im Rahmen der Patentansprüche auch alternativ ausgeführt werden.

## Patentansprüche

1. Sensorschaltungsanordnung mit einem Widerstandssensor (RT), wenigstens einem schaltenden Sensor (S1, S10, S20, S30) und wenigstens einem Hilfswiderstand (R1, R10, R20, R30), die einen Schaltkreis mit einem Summenwiderstand (RG) bilden, wobei der Summenwiderstand (RG) einerseits vom Widerstandswert des Hilfswiderstands (R1, R10, R20, R30) in Kombination mit dem Schaltzustand des schaltenden Sensors (S1, S10, S20, S30) und andererseits vom Widerstandswert des Widerstandssensors (RT) abhängig ist und wobei der Widerstandssensor (RT) ein Temperatursensor ist.

2. Sensorschaltungsanordnung nach Anspruch 1, wobei der wenigstens eine Hilfswiderstand (R1, R10, R20, R30) und der Widerstandssensor (RT) in Reihe geschaltet sind und der wenigstens eine Hilfswiderstand (R1, R10, R20, R30) vom schaltenden Sensor (S1, S10, S20, S30) überbrückbar ist.

3. Sensorschaltungsanordnung nach einem der vorhergehenden Ansprüche, wobei der wenigstens eine Hilfswiderstand (R1, R10, R20, R30) und der Widerstandssensor (RT) parallel geschaltet sind und der wenigstens eine Hilfswiderstand (R1, R10, R20, R30) vom schaltenden Sensor (S1, S10, S20, S30) ein- und ausschaltbar ist.

4. Sensorschaltungsanordnung nach einem der vorhergehenden Ansprüche, wobei wenigstens zwei schaltende Sensoren (S10, S20, S30) und wenigstens zwei Hilfswiderstände (R10, R20, R30) vorgesehen sind und die Schaltung so gewählt ist, dass jede Kombination von Schaltzuständen der schaltenden Sensoren (S10, S20, S30) eine unterschiedliche Änderung des Wertes des Summenwiderstands (RG) bewirkt.

5. Sensorschaltungsanordnung nach Anspruch 4, wobei jedem schaltenden Sensor (S10, S20, S30) ein Hilfswiderstand (R10, R20, R30) parallelgeschaltet ist und die parallelgeschalteten Komponenten mit dem Widerstandssensor RT in einer Reihenschaltung verbunden sind.

6. Sensorschaltungsanordnung nach Anspruch 5, wobei die Werte der Hilfswiderstände (R10, R20, R30) binär abgestuft sind,

7. Vorrichtung aufweisend eine Sensorschaltungsanordnung nach einem der Ansprüche 1 bis 6, an die der Widerstandssensor (RT) und der wenigstens eine schaltende Sensor (S1, S10, S20, S30) anschließbar sind und von der der Summenwiderstand (RG) an eine Auswerteeinheit (20) ausgebbar ist, weiter umfassend ein Gehäuse (10), in dem der wenigstens eine Hilfswiderstand (R1, R10, R20, R30), sowie Verbindungsmittel zur Bildung des Schaltkreises angeordnet sind.

8. Vorrichtung nach Anspruch 7, wobei die Verbindungsmittel Steck-, Schraubklemm-, Klemm- oder Lötverbinder für den Anschluss des Widerstandssensors (RT), des wenigstens einen schaltenden Sensors (S1, S10, S20, S30) und der Auswerteeinheit (20) umfassen.

9. Verfahren zur Auswertung einer Sensorschaltungsanordnung nach einem der Ansprüche 1 bis 6, mit folgenden Schritten:
- Messung des Summenwiderstands (RG),
- Ermittlung des Schaltzustandes des wenigstens einen schaltenden Sensors (S1, S10, S20, S30),
- Berechnung des Wertes des Widerstandssensors (RT) aus dem Schaltzustand des wenigstens einen schaltenden Sensors (S1, S10, S20, S30) und dem Wert des wenigstens einen Hilfswiderstands (R1, R10, R20, R30).

10. Verfahren nach Anspruch 9, wobei die Ermittlung des Schaltzustandes des wenigstens einen schaltenden Sensors folgende Schritte umfasst:
- wiederholtes Messen des Summenwiderstands (RG) in kurzen Zeitabständen,
- Feststellen eines Sprunges im Wert des Summenwiderstands (RG),
- Ermittlung des Schaltzustands des wenigstens einen schaltenden Sensors (S1, S10, S20, S30) aus Wertänderung des Summenwiderstands (RG).

11. Positionsmesseinrichtung aufweisend eine Sensorschaltungsanordnung nach einem der Ansprüche 1 bis 6, und weiter aufweisend eine Widerstandsverarbeitungseinheit (23) zur Messung des Summenwiderstands (RG) und eine Schnittstelleneinheit (22) zur Kommunikation mit einer Steuerung (30) über einen bidirektionalen Datenübertragungskanal (25).

12. Positionsmesseinrichtung nach Anspruch 11, wobei der Wert des Summenwiderstands (RG) über die Schnittstelleneinheit (22) zur Steuerung (30) übertragbar ist.

13. Positionsmesseinrichtung nach Anspruch 11, wobei die Widerstandsverarbeitungseinheit (23) ausgestaltet ist zur Feststellung des Schaltzustandes des wenigstens einen schaltenden Sensors (S1, S10, S20, S30), sowie zur Bestimmung des Wertes des Widerstandssensors (RT) und wobei der ermittelte Schaltzustand des schaltenden Sensors (S1, S10, S20, S30) und der Wert des Widerstandssensors (RT) über die Schnittstelleneinheit (22) zur Steuerung (30) übertragbar sind.

## Claims

1. Sensor circuit arrangement having a resistance sensor (RT), at least one switching sensor (S1, S10, S20, S30) and at least one auxiliary resistor (R1, R10, R20, R30) that form a circuit with a total resistance (RG), wherein the total resistance (RG) is dependent firstly on the resistance value of the auxiliary resistor (R1, R10, R20, R30) in combination with the switching state of the switching sensor (S1, S10, S20, S30) and secondly on the resistance value of the resistance sensor (RT), and wherein the resistance sensor (RT) is a temperature sensor.

2. Sensor circuit arrangement according to Claim 1, wherein the at least one auxiliary resistor (R1, R10, R20, R30) and the resistance sensor (RT) are connected in series and the at least one auxiliary resistor (R1, R10, R20, R30) is able to be bypassed by the switching sensor (S1, S10, S20, S30).

3. Sensor circuit arrangement according to either of the preceding claims, wherein the at least one auxiliary resistor (R1, R10, R20, R30) and the resistance sensor (RT) are connected in parallel and the at least one auxiliary resistor (R1, R10, R20, R30) is able to be switched on and off by the switching sensor (S1, S10, S20, S30).

4. Sensor circuit arrangement according to one of the preceding claims, wherein at least two switching sensors (S10, S20, S30) and at least two auxiliary resistors (R10, R20, R30) are provided and the circuit is selected such that each combination of switching states of the switching sensors (S10, S20, S30) brings about a different change of the value of the total resistance (RG).

5. Sensor circuit arrangement according to Claim 4, wherein an auxiliary resistor (R10, R20, R30) is connected in parallel with each switching sensor (S10, S20, S30) and the parallel-connected components are connected to the resistance sensor (RT) in a series circuit.

6. Sensor circuit arrangement according to Claim 5, wherein the values of the auxiliary resistors (R10, R20, R30) are incremented in binary form.

7. Device having a sensor circuit arrangement according to one of Claims 1 to 6, to which the resistance sensor (RT) and the at least one switching sensor (S1, S10, S20, S30) are able to be connected and by way of which the total resistance (RG) is able to be output to an evaluation unit (20), furthermore comprising a housing (10) in which the at least one auxiliary resistor (R1, R10, R20, R30) and connection means for forming the circuit are arranged.

8. Device according to Claim 7, wherein the connection means comprise plug connections, screw terminal connections, clamp connections or solder connections for connecting the resistance sensor (RT), the at least one switching sensor (S1, S10, S20, S30) and the evaluation unit (20).

9. Method for evaluating a sensor circuit arrangement according to one of Claims 1 to 6, having the following steps:
- measuring the total resistance (RG),
- determining the switching state of the at least one switching sensor (S1, S10, S20, S30),
- calculating the value of the resistance sensor (RT) from the switching state of the at least one switching sensor (S1, S10, S20, S30) and the value of the at least one auxiliary resistor (R1, R10, R20, R30).

10. Method according to Claim 9, wherein determining the switching state of the at least one switching sensor comprises the following steps:
- repeatedly measuring the total resistance (RG) at short time intervals,
- establishing a jump in the value of the total resistance (RG),
- determining the switching state of the at least one switching sensor (S1, S10, S20, S30) from a change in the value of the total resistance (RG).

11. Position measurement apparatus having a sensor circuit arrangement according to one of Claims 1 to 6, and furthermore having a resistance processing unit (23) for measuring the total resistance (RG) and an interface unit (22) for communicating with a controller (30) via a bidirectional data transmission channel (25).

12. Position measurement apparatus according to Claim 11, wherein the value of the total resistance (RG)is able to be transmitted to the controller (30) via the interface unit (22).

13. Position measurement apparatus according to Claim 11, wherein the resistance processing unit (23) is designed to establish the switching state of the at least one switching sensor (S1, S10, S20, S30) and to determine the value of the resistance sensor (RT), and wherein the determined switching state of the switching sensor (S1, S10, S20, S30) and the value of the resistance sensor (RT) are able to be transmitted to the controller (30) via the interface unit (22).

## Revendications

1. Ensemble de circuit de capteur comprenant un capteur résistif (RT), au moins un capteur à commutation (S1, S10, S20, S30) et au moins une résistance auxiliaire (R1, R10, R20, R30), qui forment un circuit ayant une résistance totale (RG), la résistance totale (RG) dépendant d'une part de la valeur de la résistance auxiliaire (R1, R10, R20, R30) en combinaison avec l'état de commutation du capteur à commutation (S1, S10, S20, S30) et d'autre part de la valeur de résistance du capteur résistif (RT) et le capteur résistif (RT) étant un capteur de température.

2. Ensemble de circuit de capteur selon la revendication 1, l'au moins une résistance auxiliaire (R1, R10, R20, R30) et le capteur résistif (RT) étant montés en série et l'au moins une résistance auxiliaire (R1, R10, R20, R30) du capteur à commutation (S1, S10, S20, S30) pouvant être pontée.

3. Ensemble de circuit de capteur selon l'une des revendications précédentes, l'au moins une résistance auxiliaire (R1, R10, R20, R30) et le capteur résistif (RT) étant montés en parallèle et l'au moins une résistance auxiliaire (R1, R10, R20, R30) du capteur à commutation (S1, S10, S20, S30) pouvant être activée et désactivée.

4. Ensemble de circuit de capteur selon l'une des revendications précédentes, au moins deux capteurs à commutation (S10, S20, S30) et au moins deux résistances auxiliaires (R10, R20, R30) étant prévus et le circuit étant sélectionné de telle sorte que chaque combinaison d'états de commutation des capteurs à commutation (S10, S20, S30) entraîne un changement différent de la valeur de la résistance totale (RG).

5. Ensemble de circuit de capteur selon la revendication 4, une résistance auxiliaire (R10, R20, R30) étant montée en parallèle avec chaque capteur à commutation (S10, S20, S30) et les composants montés en parallèle étant reliés au capteur résistif RT dans un montage en série.

6. Ensemble de circuit de capteur selon la revendication 5, les valeurs des résistances auxiliaires (R10, R20, R30) étant graduées de manière binaire.

7. Dispositif comprenant un ensemble de circuit de capteur selon l'une des revendications 1 à 6, dispositif auquel peuvent être reliés le capteur résistif (RT) et au moins un capteur à commutation (S1, S10, S20, S30) et à partir duquel la résistance totale (RG) peut être délivrée à une unité d'évaluation (20), ledit dispositif comprenant en outre un boîtier (10) dans lequel l'au moins une résistance auxiliaire (R1, R10, R20, R30) et des moyens de liaison sont disposés pour former le circuit.

8. Dispositif selon la revendication 7, les moyens de liaison comprenant des connecteurs à enfichage, à vis, à pince ou à souder destinés à relier le capteur résistif (RT), l'au moins un capteur à commutation (S1, S10, S20, S30) et l'unité d'évaluation (20).

9. Procédé d'évaluation d'un ensemble de circuit de capteur selon l'une des revendications 1 à 6, ledit procédé comprenant les étapes suivantes :
- mesurer la résistance totale (RG),
- déterminer l'état de commutation de l'au moins un capteur à commutation (S1, S10, S20, S30),
- calculer la valeur du capteur résistif (RT) à partir de l'état de commutation de l'au moins un capteur à commutation (S1, S10, S20, S30) et de la valeur de l'au moins une résistance auxiliaire (R1, R10, R20, R30).

10. Procédé selon la revendication 9, la détermination de l'état de commutation de l'au moins un capteur à commutation comprenant les étapes suivantes :
- mesurer de manière répétée la résistance totale (RG) sur de courts intervalles de temps,
- détecter un saut dans la valeur de la résistance totale (RG),
- déterminer l'état de commutation de l'au moins un capteur à commutation (S1, S10, S20, S30) à partir d'un changement de valeur de la résistance totale (RG).

11. Moyen de mesure de position comprenant un ensemble de circuit de capteur selon l'une des revendications 1 à 6, et comprenant en outre une unité de traitement de résistance (23) destinée à mesurer la résistance totale (RG) et une unité d'interface (22) destinée à la communication avec une commande (30) par le biais d'un canal de transmission de données bidirectionnel (25).

12. Moyen de mesure de position selon la revendication 11, la valeur de la résistance totale (RG) pouvant être transmise à la commande (30) par le biais de l'unité d'interface (22).

13. Moyen de mesure de position selon la revendication 11, l'unité de traitement de résistance (23) étant conçue pour détecter l'état de commutation de l'au moins un capteur à commutation (S1, S10, S20, S30) et pour déterminer la valeur du capteur résistif (RT) et l'état de commutation déterminé du capteur à commutation (S1, S10, S20, S30) et la valeur du capteur résistif (RT) pouvant être transmis à la commande (30) par le biais de l'unité d'interface (22).
